# EUROPEAN PATENT APPLICATION

(11) **EP 4 376 096 A1**
(43) Date of publication of application: **29.05.2024**
(21) Application number: 23155496.5
(22) Date of filing: 08.02.2023
(51) Int. Cl.: H01L 31/02, H01L 31/0352, H01L 31/0392, H01L 31/075

(54) **WRAPPED PHOTOVOLTAIC CELL AND PHOTOVOLTAIC MODULE**

(30) Priority: 24.11.2022 CN 202211496047; 24.11.2022 CN 202223154516 U
(71) Applicant: Jiang, Fei, Beijing City 100089 (CN)
(72) Inventor: Jiang, Fei, Beijing City, 100089 (CN); Wang, Tongle, Beijing, 100195 (CN); Yan, Runwan, Beijing, 100021 (CN); Jiang, Bingchen, Beijing, 100089 (CN)
(74) Representative: Vesterinen, Jussi Tapio

(57) **Abstract**

The present disclosure provides a wrapped photovoltaic cell and a photovoltaic module, and relates to the technical field of photovoltaic cells and modules. The wrapped photovoltaic cell includes a unit cell module, the unit cell module includes an inner electrode, a photosensitive and charge transport layer and a transparent outer electrode, the inner electrode is connected with a first lead, the transparent outer electrode is connected with a second lead, the photosensitive and charge transport layer and the transparent outer electrode are successively wrapped outside the inner electrode, and the photovoltaic module includes the wrapped photovoltaic cell. According to the present disclosure, the wrapped structure is used, which allows surrounding light to enter the photosensitive and charge transport layer so as to realize front incidence within a large range, with high lighting efficiency and high light energy utilization rate; moreover, if the wrapped photovoltaic cell is arranged in a linear and strip-shaped structures, the wrapped photovoltaic cell can be bent and folded at will, which is convenient for laying or weaving into various shapes. Therefore, the wrapped photovoltaic cell is applicable to a variety of scenes and has a wide application range.

## Description

### TECHNICAL FIELD

The present disclosure relates to the technical field of photovoltaic cells and modules, particularly to a wrapped photovoltaic cell and a photovoltaic module.

### BACKGROUND

A photovoltaic cell is a device for converting light energy into electric energy by utilizing a photovoltaic effect, which is a photoelectric semiconductor chip that can directly generate electricity by absorbing light. The photovoltaic cell mainly utilizes semiconductor PN junction characteristics. There is a carrier concentration difference in a PN junction, most of carriers form a spatial change zone after being diffused and composited, and a built-in electric field is formed inside the spatial charge zone, so as to allow most of carriers to reverse drift and finally achieve dynamic balance. The light is irradiated on the PN junction, when the photon energy is greater than the band gap width of the PN junction material, an electron hole pair is generated near the PN junction. Under the effect of the built-in electric field, the electron hole pair is separated to drift towards the two ends of the spatial charge zone to generate a photogenerated potential. At this moment, if its two ends are connected with an external electrical circuit, a current will be formed, which is called the photogenerated voltaic effect, a photovoltaic effect for short. The spatial charge zone of the PN junction is at the interface of P-type and N-type materials, and the barrier thickness of the built-in electric field is limited. If an intrinsic i layer is added in the middle of the PN junction, the built-in electric field will run through the entire i layer. Because the thickness of the i layer is greater than that of the interface, the i layer can absorb a large number of photons and convert them into carriers, thus improving the sensitivity.

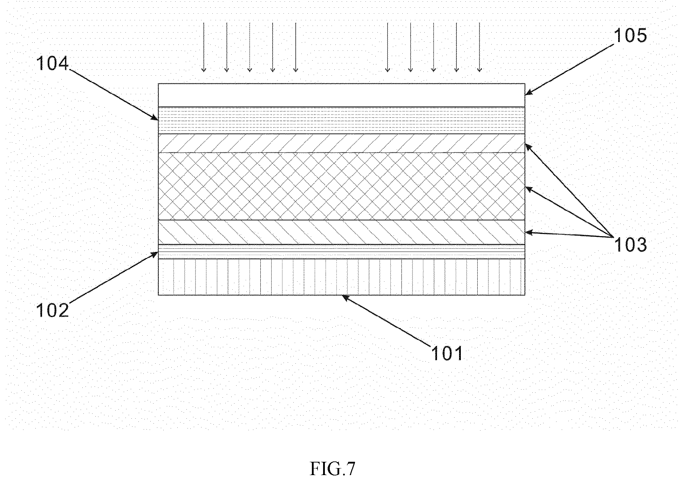

The photovoltaic cell is mainly applied to solar power generation, so it is also called a solar cell. According to different semiconductor material forms, the solar cell can be divided into a crystalline silicon solar cell and a thin-film solar cell. At present, the crystalline silicon cell is the mainstream of the solar cell, which belongs to a first-generation solar cell technology that is first studied and first applied. Depending on different material forms, the crystalline silicon cell can be divided into a monocrystalline silicon cell and a polycrystalline silicon cell. The crystalline silicon cell is obtained by slicing a monocrystalline silicon rod or a polycrystalline silicon ingot, and then making the PN junction and an electrode on its surface and then packaging. The thickness of the silicon chip is generally 160-190 µm. Therefore, the crystalline silicon cell is relatively thick, which is a rigid cell. In order to expand the application of the photovoltaic cell, the thin-film cells is currently also developed. The thin-film cell with only a few µm of thickness is mainly made by vacuum deposition or liquid printing. Therefore, the thin-film cell it has flexibility when being made on a flexible substrate and has a wide application range. At present, mature thin-film cell materials include amorphous silicon, GaAs, CdTe, CIGS, a perovskite cell, a dye-sensitized cell, an organic compound cell, etc. However, due to limitations from lighting area, production process, product characteristics and the like, both the crystalline silicon cells and thin-film cells are of planar structures, and typical structures are shown in FIG. 7.

The existing planar cell is of a planar hierarchical structure. A lower electrode 102 is made on a substrate 101, and then the existing photosensitive and charge transport layer 103, the existing transparent upper electrode 104 and the existing transparent protecting layer 105 are made in turn. The main structure of the planar cell is characterized by parallel plane layout of layers. Generally, the existing photosensitive and charge transport layer 103 has multiple structures, such as p-i-n, n-i-p, p-n, n-p type structures, according to different use materials, and built-in electric fields are formed between pn junctions from top to bottom or from bottom to top. The light passes through the existing transparent protecting layer 105 and the transparent upper electrode 104 on the upper surface to reach the existing photosensitive and charge transport layer 103 so as to excite the photosensitive material to form holes and electrons, and the hole and electron pairs move to upper and lower electrodes via the built-in electric field in the PN junction and then lead out after reaching the upper and lower electrodes to form a current.

The only upper surface of the photovoltaic cell with a planar structure can receive light, and the scattered light on the side surface and the back surface cannot be utilized, thus lighting is limited, with a low light energy utilization rate.

In addition, the cell with the planar structure cannot be applied without shape diversity in many occasions. Even for the existing planar flexible cell, it can bear curling to a certain extent, but can be folded and bent to a limited degree. Hence, the existing planar flexible cell has limited use and a small application range.

### SUMMARY

The objective of the present disclosure is to provide a wrapped photovoltaic cell and a photovoltaic module to solve the problems of low lighting efficiency and small application range of a planar photovoltaic cell in the prior art. Preferred technical solutions in many technical solutions provided by the present disclosure have many technical effects; details are described hereafter.

In order to realize the above objective, the present disclosure provides the following technical solution:
The present disclosure provides a wrapped photovoltaic cell, comprising unit cell modules, the unit cell module comprising an inner electrode, a photosensitive and charge transport layer and a transparent outer electrode, wherein: the inner electrode is connected with a first lead, the transparent outer electrode is connected with a second lead; and the photosensitive and charge transport layer and the transparent outer electrode are successively wrapped outside the inner electrode.

Preferably, the photosensitive and charge transport layer is arranged in a multi-layer structure, and comprises a p-type transport layer and an n-type transport layer which are arranged along the normal direction of the surface of the inner electrode to form a built-in electric field distributed along the normal direction.

Preferably, the photosensitive and charge transport layer comprises an i-type photosensitive layer which is arranged between the p-type transport layer and the n-type transport layer.

Preferably, a modification layer is arranged between adjacent layers of the photosensitive and charge transport layer; a modification layer is arranged between the photosensitive and charge transport layer and the inner electrode; a modification layer is arranged between the photosensitive and charge transport layer and the transparent outer electrode.

Preferably, the wrapped photovoltaic cell comprises a transparent protecting layer which is wrapped outside the unit cell module.

Preferably, the wrapped photovoltaic cell is arranged in a partial wrapping structure, the photosensitive and charge transport layer and the transparent outer electrode are successively wrapped on the partial outer wall of the inner electrode, and the transparent protecting layer is wrapped outside the outer electrode; the unwrapped part of the inner electrode forms the first lead; or, the first lead is led out by the unwrapped part of the inner electrode to penetrate through the transparent protecting layer; or, the first lead is led out by the wrapped part of the inner electrode to successively penetrate through the photosensitive and charge transport layer, the transparent outer electrode and the transparent outer electrode.

Preferably, the wrapped photovoltaic cell is arranged in a complete wrapping structure, the photosensitive and charge transport layer, the transparent outer electrode and the transparent protecting layer are successively wrapped on all the outer walls of the inner electrode, and the first lead successively penetrates through the charge transport layer, the transparent outer electrode and the transparent protecting layer, and the part of the first lead contacting with each layer is insulated.

Preferably, the inner electrode is arranged in a linear, columnar, strip, sheet, radial, spherical, partial spherical, polyhedral or curved shape and the like, the photosensitive and charge transport layer, the transparent outer electrode and the transparent protecting layer are all adaptive to the inner electrode.

Preferably, the unit cell module includes a plurality of photosensitive and charge transport layers, the photosensitive and charge transport layers are successively wrapped between the inner electrode and the transparent protecting electrode, and a charge composite layer is arranged between adjacent photosensitive and charge transport layers.

Preferably, the quantity of the unit cell modules is plural, and all the unit cell modules are connected in series or in parallel.

The present disclosure provides a photovoltaic module, comprising any wrapped photovoltaic cell as described above.

The wrapped photovoltaic cell and the photovoltaic module provided by the present disclosure at least have the following beneficial effects:
The wrapped photovoltaic cell and the photovoltaic module provided by the present disclosure have the following beneficial effects:
The wrapped photovoltaic cell includes the unit cell module, the unit cell module includes the inner electrode, the photosensitive and charge transport layer and the transparent outer electrode. The inner electrode is connected with a first lead, and the transparent outer electrode is connected with a second lead. During the working, the light passes through the transparent outer electrode to reach the photosensitive and charge transport layer to excite electron hole pairs, the electron holes pairs are separated in the built-in electric field and then transported to the inner electrode and the transparent outer electrode along the normal direction and then flow to the lead and drained to external charges through the lead to supply electricity to the outside.

The photosensitive and charge transport layer and the transparent outer electrode are successively wrapped outside the inner electrode. By adoption of the wrapping structure, the surrounding light can enter the photosensitive and charge transport layer. Compared with the planar cell, the light can achieve front incidence in a relatively large range, lighting efficiency is high, and light energy utilization rate is high. Furthermore, the structure of the wrapped photovoltaic cell mainly depends on the inner electrode, if the inner electrode is of a linear and strip shaped, the wrapped photovoltaic cell can be bent and folded at will so as to facilitate laying or knitting of various shapes, and is suitable for many scenes and has wide range.

The unit cell module of the present disclosure is of a wrapping structure, which leads to not only high light utilization rate and efficient lighting efficiency, but also flexible structure. The unit cell module can be arranged as different structure shapes according to actual demands, is suitable many application situations and has wide application range. In addition, the full-covering state of the protecting layer allows most of most photosensitive materials to be isolated from external factors such as air and water vapor, thereby improving the service life and reliability of the product.

### BRIEF DESCRIPTION OF THE DRAWINGS

For more clearly illustrating the embodiments of the present disclosure or technical solution in the prior art, accompanying drawings required for use in the descriptions of the embodiments or in the prior art will be described below, obviously, the accompanying drawings in the following description are only some embodiments of the present disclosure, and other drawings can also be obtained by persons of ordinary skill in the art without creative efforts according to these drawings.
FIG.1 is a structural diagram of a wrapped photovoltaic cell according to the present disclosure;
FIG.2 is a structural diagram of a wrapped linear photovoltaic cell according to the present disclosure;
FIG.3 is a sectional diagram of a wrapped linear or spherical partially wrapped photovoltaic cell according to the present disclosure;
FIG.4 is a structural diagram of a wrapped spherical photovoltaic cell according to the present disclosure;
FIG.5 is a structural diagram of a wrapped spherical multi-layer photovoltaic cell according to the present disclosure;
FIG.6 is a structural diagram of a wrapped linear photovoltaic cell that is connected in series according to the present disclosure;
FIG.7 is a structural diagram of current plane photovoltaic cell.

### Reference number

1, inner electrode; 11, inner insulating layer; 12, outer conducting layer; 2. photosensitive and charge transport layer; 21, p-type transport layer; 22, n-type transport layer; 23, i-type photosensitive layer; 3, transparent outer electrode; 4, transparent protecting layer; 5, first lead; 6, second lead; 7, insulating layer; 8, charge composite layer; 101, base plate ; 102, lower electrode; 103, existing photosensitive and charge transport layer; 104, transparent upper electrode; 105, existing transparent protecting layer.

### DETAILED DESCRIPTION OF THE EMBODIMENTS

In order to make the purpose, technical scheme and advantages of the present disclosure clearer, the technical scheme of the present disclosure will be described in detail below. Obviously, the described embodiments are only part of the embodiments of the present disclosure but not all the embodiments. Based on the embodiments of the present disclosure, all other embodiments obtained by persons of ordinary skill in the art without creative efforts belong to the protective scope of the present disclosure.

### Example 1

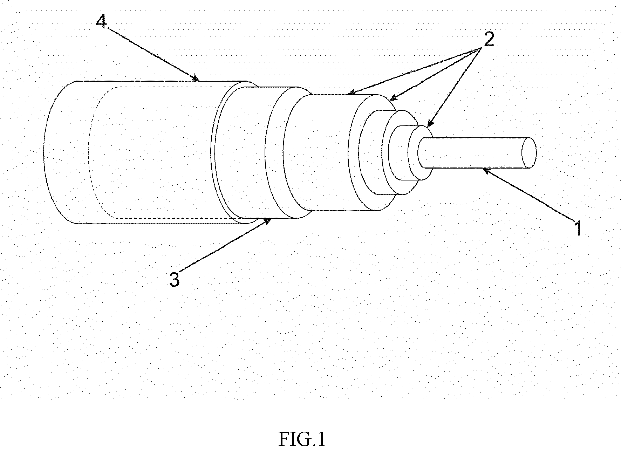

The present disclosure provides a wrapped photovoltaic cell, as shown in FIG. 1. The wrapped photovoltaic cell includes a unit cell module, which includes an inner electrode 1, a photosensitive and charge transport layer 2, and a transparent outer electrode 3.

The inner electrode 1 is connected with a first lead 5, and the transparent outer electrode 3 is connected with a second lead 6, the inner electrode 1 can be arranged as a solid core structure or a hollow structure, the transparent outer electrode 3 needs to have good conductivity and light transmittance, the photosensitive and charge transport layer 2 and the transparent outer electrode 3 are successively wrapped outside the inner electrode 1 along the normal direction, and a built-in electric field can be distributed in the photosensitive and charge transport layer 2 along the normal direction.

When in use, the first lead 5 and the second lead 6 are connected with external loads.

The light incident from the surrounding direction passes through the transparent outer electrode 3 to reach the photosensitive and charge transport layer 2 to excite electron hole pairs, and the electron hole pairs are separated by the built-in electric field and then flow through the first lead 5 and the second lead 6 respectively via the inner electrode 1 and the transparent outer electrode 3, so as to supply electricity to the external load.

The inner electrode (1), the photosensitive and charge transport layer (2) and the transparent outer electrode (3) adopt a wrapping structure, which can collect surrounding light, and significantly improve the lighting efficiency and light energy utilization compared with the existing planar photovoltaic cell. Moreover, the wrapped photovoltaic cell has a flexible structure, different structural shapes can be set according to the needs of actual users, and therefore the wrapped photovoltaic cell is applicable to a variety of scenarios and a wide application range.

### Example 2

Example 2 is based on example 1.

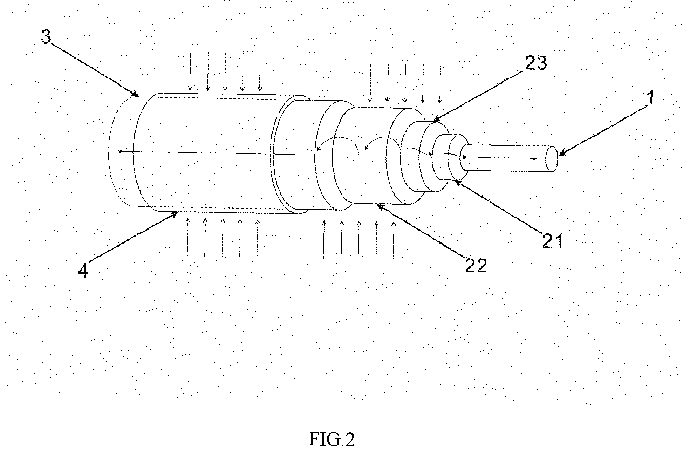

As shown in FIG.1 and FIG.2, the photosensitive and charge transport layer 2 is arranged as a multi-layer structure, and the photosensitive and charge transport layer 2 includes a p-type transfer layer 21 and an n-type transfer layer 22 which are arranged along the normal direction to form a built-in electric field distributed along the normal direction.

Optionally, the p-type transport layer 21 is located in the inner layer, the n-type transport layer 22 is located in the outer layer, and the photosensitive and charge transport layer 2 is in a p-n type structure from the inside to the outside.

Alternatively, the p-type transport layer 21 is located in the outer layer, the n-type transport layer 22 is located in the inner layer, and the photosensitive and charge transport layer 2 is in an n-p structure from the inside to the outside.

As an optional embodiment, the photosensitive and charge transport layer 2 includes an i-type photosensitive layer 23, which is arranged between the p-type transfer layer 21 and the n-type transfer layer 22, and can form a p-i-n-type structure and an n-i-p-type structure.

The photosensitive material of the i-type photosensitive layer 23 can adopt group IV semiconductor materials such as silicon base and selenium base, group III-V semiconductor materials such as GaAs, group II-VI semiconductor materials such as CdTe, compound materials such as CIGS, halide materials, perovskite materials, dye sensitized cell materials, organic compound cell materials, etc.

The materials of the p-type transmission layer and the n-type transmission layer are adaptively selected according to the actual photosensitive materials of the i-type photosensitive layer 23.

As shown in FIG.2, during the working, due to diffusion of carriers, a built-in electric field from the n-type transport layer 22 to the p-type transport layer 21 is formed between the p-type transport layer 21, the i-type photosensitive layer 23 and the n-type transport layer 22. When the light passes through the transparent outer electrode 3 to reach the i-type photosensitive layer 23, the i-type photosensitive layer 23 can absorb photons whose energies are greater than an energy gap, and excites valence band electrons into a conduction band to form an electron hole pair. Under the action of the built-in electric field, the electrons and holes are separated, wherein, the electrons move to the transparent outer electrode 3 in a direction opposite to the direction of the built-in electric field (that is, a direction from the i-type photosensitive layer 23 to the n-type transmission layer 22), the holes move to the inner electrode 1 in the direction of the built-in electric field (that is, from the i-type photosensitive layer 23 to the p-type transmission layer 21), the electrons and holes are led out through the lead respectively after reaching the transparent outer electrode 3 and the inner electrode to form a current.

Alternatively, for some single layers, a cell made of a mixed type or molecule type D-A material has no a multi-layer structure comprising an obvious p-type transport layer 21, an i-type photosensitive layer 23 and an n-type transport layer 22, charges are formed at an interface between a donor and a receptor, then migrates to the inner electrode 1 and the transparent outer electrode 3 that are in energy level matching from the internal of the donor and receptor materials.

As an optional embodiment, a modification layer can be arranged between adjacent layers of the photosensitive and charge transport layer 2, a modification layer is arranged between the photosensitive and charge transport layer 2 and the inner electrode 1, and a modification layer is arranged between the photosensitive and charge transport layer 2 and the transparent outer electrode 3.

By optimizing each interface, the charges can be well led out, so as to effectively increase the cell conversion efficiency.

As an optional embodiment, as shown in FIG. 1 and FIG.2, the wrapped photovoltaic cell includes a transparent protecting layer 4 which is wrapped outside the unit cell module.

The transparent protecting layer 4 is an insulating material, which has good light transmittance, water resistance, oxidation resistance, corrosion resistance, wear resistance and the like, and is capable of effectively protecting the surface of the cell.

The transparent protecting layer 4 can adopt a glass coating, an organic coating, transparent ceramics, etc.

As an optional embodiment, as shown in FIG. 1 and FIG.2, the wrapped photovoltaic cell is arranged in a partially wrapping structure, the photosensitive and charge transport layer 2, the transparent outer electrode 3 and the transparent protecting layer 4 are successively wrapped on the peripheral wall of the inner electrode 1, the end of the inner electrode 1 is unwrapped, and the first lead 5 is led out from the end of the inner electrode 1.

The inner electrode 1 is arranged as a linear, columnar, strip, sheet or radial shape, the photosensitive and charge transport layer 2, the transparent outer electrode 3 and the transparent protecting layer 4 are all adaptive to the inner electrode 1, the inner electrode 1 is of a solid core structure or a hollow structure, the inner electrode 1 can adopt metal filaments, metal wires, metal tubes, carbon fibers, conducting fibers and the like, or can also adopt insulating wires, insulating filaments, insulating fibers, insulating tubes and the like wrapped with the conducting layers on the outer surface.

The transparent outer electrode 3 can adopt a transparent conducting thin film, such as an indium tin oxide (ITO) transparent conducting thin film and fluorine-doped tin oxide (FTO) transparent conducting thin film, or can adopt a conducting grid filled with a transparent material, such as a metal mesh and a carbon fiber mesh.

As shown in FIG. 1 and FIG.2, example 2 shows a linear wrapped photovoltaic cell. The linear wrapped photovoltaic cell is diverse cross section, the diameter of the linear wrapped photovoltaic cell can be set as needed, the linear wrapped photovoltaic cell has good flexibility and can be knitted according to actual situations, so as to form a large-area cell module which not only has large lighting surface but also meets various application demands.

### Example 3

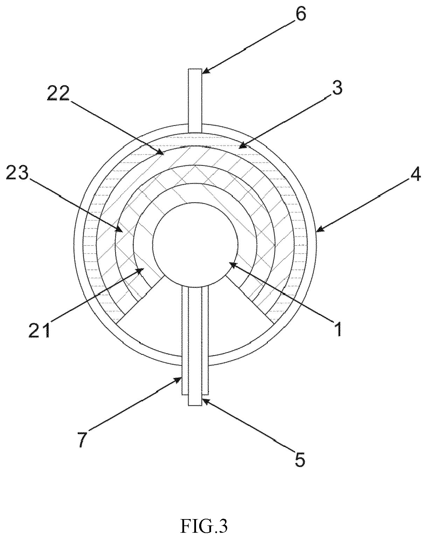

Example 3 differs from example 2 in that:
As shown in FIG.3, the wrapped photovoltaic cell is arranged in a partially wrapping structure, the photosensitive and charge transport layer 2 and the transparent outer electrode 3 are successively wrapped on the partial outer wall of the inner electrode 1, and the transparent protecting layer 4 is completely wrapped outside the transparent outer electrode 3.

The inner electrode 1 is arranged in a linear, columnar, strip, sheet, radial, spherical, partial spherical, polyhedral or curved shape, and the photosensitive and charge transport layer 2, transparent outer electrode 3 and the transparent protecting layer 4 are all adaptive to the inner electrode 1. The inner electrode 1 can adopt metal wires, metal filaments, metal tubes, metal strips, metal blocks, carbon fibers, conducting fibers, metal balls, partial metal spheres, metal polyhedrons, metal curved surfaces and the like, or can adopt insulating wires, insulating columns, insulating sheets, insulating strips, insulating spheres, partial insulating spheres, insulating polyhedrons, insulating curved surfaces whose outer surfaces are wrapped with conducting layers.

Optionally, the unwrapped part of the inner electrode 1 can penetrate through the transparent protecting layer 4 to form the first lead 5.

Alternatively, the wrapped part of the inner electrode 1 is connected with the first lead 5 and successively penetrates through the photosensitive and charge transport layer 2, the transparent outer electrode 3 and the transparent protecting layer 4.

When the first lead 5 passes through the photosensitive and charge transport layer 2 and the transparent outer electrode 3, an insulating layer 7 shall be arranged outside the first lead 5 to avoid electric contact.

As shown in FIG.3, the linear or spherical photovoltaic cells partially wrapped on their surrounding walls in example 3 are shown. The specific positions, shapes and structures of the wrapped and unwrapped photovoltaic cells can be set according to actual needs.

### Example 4

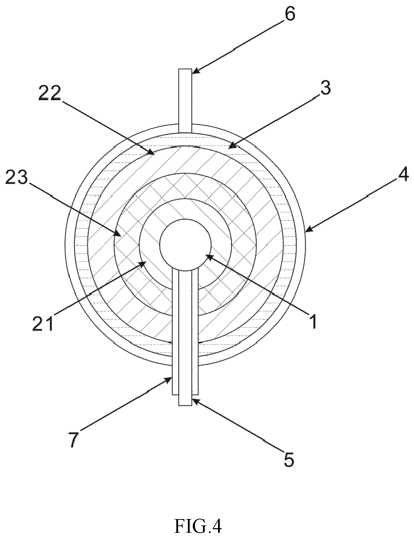

Example 4 differs from example 3 in that:
As shown in FIG.4, the wrapped photovoltaic cell is arranged in a completely wrapping structure, the photosensitive and charge transport layer 2, the transparent outer electrode 3 and the transparent protecting layer 4 are successively wrapped outside the inner electrode 1. The first lead 5 passes through the photosensitive and charge transport layer 2, the transparent outer electrode 3 and the transparent protecting layer 4 in turn. The outer side of the first lead 5 is provided with an insulating layer 7 to avoid the first lead 5 from contacting other layers.

The inner electrode 1 is arranged in a linear, columnar, strip, sheet, radial, spherical, partial spherical, polyhedral or curved shape, and the photosensitive and charge transport layer 2, the transparent outer electrode 3 and the transparent protecting layer 4 are adaptive to the inner electrode 1.

Considering the weight of the wrapped photovoltaic cell, the inner electrode 1 being in a spherical, partially spherical, polyhedral or curved shape is generally in a hollow structure.

As shown in FIG.4, the spherical wrapped photovoltaic cell in example 4 is shown. The spherical diameter of the spherical wrapped photovoltaic cell can be set according to the actual needs. The spherical wrapped photovoltaic cell collects light energy in all directions to ensure that the straight radiation of light can be realized at any angles, thereby further expanding application requirements.

The cells given in example 2 and example 4 are both of a single cell structure.

### Example 5

Example 5 is based on example 4.

The unit cell module includes a plurality of photosensitive and charge transport layers 2. All of the photosensitive and charge transport layers 2 are successively wrapped between the inner electrode 1 and the transparent outer electrode 3, and a charge composite layer 8 is arranged between adjacent photosensitive and charge transport layers 2.

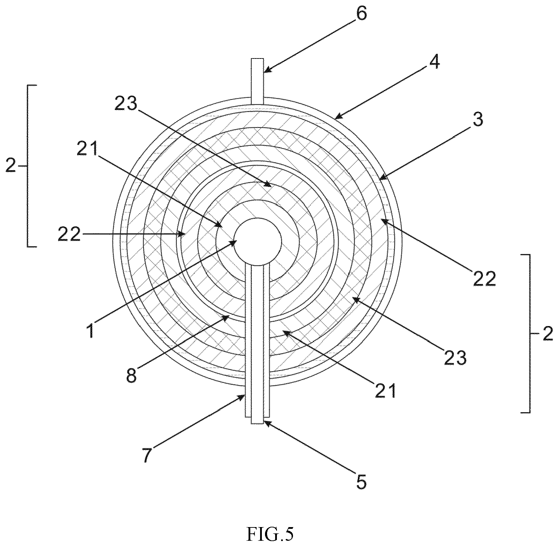

As shown in FIG.5, FIG.5 shows a spherical double-stack wrapped photovoltaic cell. The photovoltaic cell includes two n-i-p layer structure cells which are laminated. The direction of the built-in electric field of each n-i-p layer structure is directed from the center of the sphere to the surface of the sphere. Therefore, during the working, the electrons move to the center of the sphere along the normal direction, and the holes move to the sphere along the normal direction. The electrons of the cell on the inner layer are led out through the inner electrode 1 and the first lead 5, and the holes reach the charge composite layer 8, the holes of the cell on the outer layer are led out through the transparent outer electrode 3 and the second lead 6, and the electrons reach the charge composite layer 8. The holes of the cell on the inner layer and the electrons of the cell on the outer layer are compounded on the charge composite layer 8.

To ensure the efficiency of the cell on the inner layer, the charge composite layer 8 should have good light transmittance.

Similarly, the wrapped photovoltaic cell includes two p-i-n layer structures, or two p-n layer structures or p-n layer structures.

Example 5 is a spherical, partially spherical, polyhedral or curved multilayer coated photovoltaic cell.

### Example 6

Example 6 is based on example 2.

The unit cell module includes a plurality of photosensitive and charge transport layers 2. All of the photosensitive and charge transport layers 2 are successively wrapped between the inner electrode 1 and the transparent outer electrode 3, and a charge composite layer 8 is arranged between the adjacent photosensitive and charge transport layers 2.

Example 6 is a linear, columnar, strip, sheet and radial multilayer coated photovoltaic cell.

### Example 7

Example 7 is based on any of the above examples.

The number of the unit cell modules is plural. All of the unit cell modules are connected in series or in parallel. The unit cell modules are connected in series and have high output voltage. The unit cell modules are connected in parallel and have large output current. In the process of actual use, users can make choices according to actual needs.

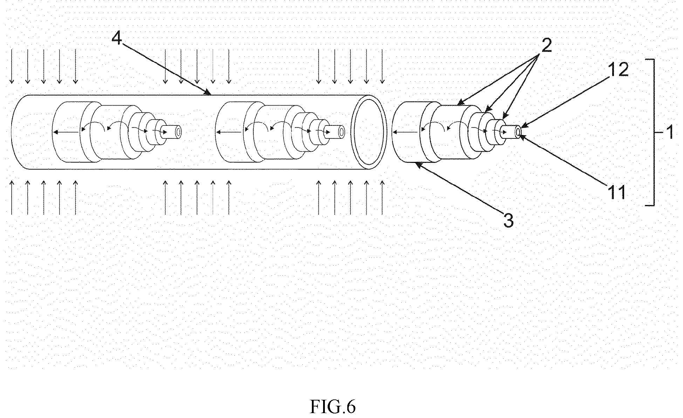

As shown in FIG.6, FIG.6 shows a series structure of a linear wrapped photovoltaic cell. Three of the cell modules are successively arranged in the transparent protecting layer 4, and connected in series along the axis. The axial series connection can ensure the consistency of the photoelectric current of a series connected cell pack, so that light can be collected from the circumferential surface of the cell pack.

The structures of the series cell need to meet two requirements:
First, the inner electrode 1 of the unit cell module has at least two layers of structures, including an inner insulating layer 11 and an outer conducting layer 12, wherein the inner insulating layer 11 is made of an insulating material that can be an insulating wire, an insulating tube or an insulating fiber. The outer conducting layer 12 needs to have good conductivity.

Second, in the wrapping process of each layer, each layer needs to be cut. According to the different types of series connection, each layer can be cut along the axial direction or the normal direction. By taking the axial series connection of three of the unit cell modules in FIG.6 as an example, the unit cell modules are cut along the normal direction, specifically:
First, the prepared inner electrode 1 is circumferentially cut according to the structure of the three cell modules, and the outer conducting layer 12 is divided into three independent unit segments. In the process of circumferentially cutting, it is needed to ensure the integrity of the inner insulating layer 11, in such the way, the continuity of the final cell pack can be effectively ensured.

Secondly, the photosensitive and charge transport layer 2 is wrapped outside the inner electrode 1 and circumferentially cut to form three independent unit segments, and an outer electrode through-hole channel should be left in a gap between adjacent two ends.

After that, the transparent outer electrode 3 is made, and the transparent outer electrode 3 is wrapped outside the photosensitive and charge transport layer 2 and circumferentially cut for the third time to form three independent cell segments. At this moment, three independent unit cell modules are formed.

After three times of circumferentially cutting and film formation, the inner and outer electrodes of the three cell modules are connected in series through notches. In order to protect the cell pack, the transparent insulating protecting layer is made on the outermost layer to complete the fabrication.

### Example 8

The present disclosure provides a photovoltaic module. The photovoltaic module includes the wrapped photovoltaic cell.

The photovoltaic module with the wrapped photovoltaic cell is flexible in structure, suitable for a variety of application scenarios, has a wide application range, and can collect light energy from multiple angles, with significant collection effect and high light energy utilization rate.

In the description of the present application, it should be understood that the orientation or position relationship indicated by terms "up", "down", "inside", "outside", "top", "bottom" and the like is an orientation or position relationship based on the drawings, which is only for the convenience of describing the present application and simplifying the description, instead of indicating or implying that the indicated device or element must have a specific orientation, and constructed and operated in a specific orientation, Therefore, it cannot be understood as a limitation on the present application.

In addition, the terms "first" and "second" are only used for the purpose of description and cannot be understood as indicating or implying relative importance or implicitly indicating the number of indicated technical features. Thus, the features defined as "first" and "second" can explicitly or implicitly include at least one such feature. In the description of the present application, "multiple" and "several" mean at least two, such as two, three, unless otherwise specifically defined.

In the present application, unless otherwise specified and defined, the terms "installation", "link", "connection", "fixed" and other terms should be understood in a broad sense, for example, they can be fixed connection, removable connection, or integrated; it can be directly connected or indirectly connected through an intermediate medium. It can be the connection between two elements or the interaction between two elements, unless otherwise specified. For ordinary technicians in the art, the specific meaning of the above terms in the application can be understood according to the specific situation.

The above description is only the specific embodiment of the present disclosure, but the protection scope of the present disclosure is not limited thereto. Any person familiar with the technical field can easily think of changes or replacements within the technical scope disclosed by the present disclosure, which should be covered in the protection scope of the present disclosure. Therefore, the protective scope of the present disclosure shall be based on the protective scope of the appended claims.

## Claims

1. A wrapped photovoltaic cell, comprising unit cell modules, the unit cell module comprising an inner electrode, a photosensitive and charge transport layer and a transparent outer electrode, wherein:
the inner electrode is connected with a first lead, the transparent outer electrode is connected with a second lead; and
the photosensitive and charge transport layer and the transparent outer electrode are successively wrapped outside the inner electrode.

2. The wrapped photovoltaic cell according to claim 1, wherein the photosensitive and charge transport layer is arranged in a multi-layer structure, and comprises a p-type transport layer and an n-type transport layer which are arranged along the normal direction of the surface of the inner electrode to form a built-in electric field distributed along the normal direction.

3. The wrapped photovoltaic cell according to claim 2, wherein the photosensitive and charge transport layer comprises an i-type photosensitive layer which is arranged between the p-type transport layer and the n-type transport layer.

4. The wrapped photovoltaic cell according to claim 3, wherein a modification layer is arranged between adjacent layers of the photosensitive and charge transport layer;
a modification layer is arranged between the photosensitive and charge transport layer and the inner electrode;
a modification layer is arranged between the photosensitive and charge transport layer and the transparent outer electrode.

5. The wrapped photovoltaic cell according to claim 2 or 3, wherein the wrapped photovoltaic cell comprises a transparent protecting layer which is wrapped outside the unit cell module.

6. The wrapped photovoltaic cell according to claim 5, wherein the photosensitive and charge transport layer and the transparent outer electrode are successively wrapped on the partial outer wall of the inner electrode, and the transparent protecting layer is wrapped outside the outer electrode;
the unwrapped part of the inner electrode forms the first lead;
or, the first lead is led out by the unwrapped part of the inner electrode to penetrate through the transparent protecting layer;
or, the first lead is led out by the wrapped part of the inner electrode to successively penetrate through the photosensitive and charge transport layer, the transparent outer electrode and the transparent outer electrode.

7. The wrapped photovoltaic cell according to claim 5, wherein the photosensitive and charge transport layer, the transparent outer electrode and the transparent protecting layer are successively wrapped on all the outer walls of the inner electrode, and the first lead successively penetrates through the charge transport layer, the transparent outer electrode and the transparent protecting layer.

8. The wrapped photovoltaic cell according to claim 1, wherein the unit cell module comprises a plurality of photosensitive and charge transport layers, the photosensitive and charge transport layers are successively wrapped between the inner electrode and the transparent protecting electrode, and a charge composite layer is arranged between adjacent photosensitive and charge transport layers.

9. The wrapped photovoltaic cell according to claim 1, wherein the quantity of the unit cell modules is plural, and all the unit cell modules are connected in series or in parallel.

10. A photovoltaic module, comprising the wrapped photovoltaic cell according to any one of claims 1-9.

## Amended claims

### Amended claims in accordance with Rule 137(2) EPC.

1. A wrapped photovoltaic cell, comprising unit cell modules, the unit cell module comprising an inner electrode (1), a photosensitive and charge transport layer (2) and a transparent outer electrode (3), wherein:
the inner electrode (1) is connected with a first lead (5), the first lead (5) passes through the photosensitive and charge transport layer (2) and the transparent outer electrode (3), the transparent outer electrode (3) is connected with a second lead (6), the outer side of the first lead (5) is provided with an insulation layer (7); and
the photosensitive and charge transport layer (2) and the transparent outer electrode (3) are successively wrapped outside the inner electrode (1).

2. The wrapped photovoltaic cell according to claim 1, wherein the photosensitive and charge transport layer (2) is arranged in a multi-layer structure, and comprises a p-type transport layer (21) and an n-type transport layer (22) which are arranged along the normal direction of the surface of the inner electrode (1) to form a built-in electric field distributed along the normal direction.

3. The wrapped photovoltaic cell according to claim 2, wherein the photosensitive and charge transport layer (2) comprises an i-type photosensitive layer (23) which is arranged between the p-type transport layer (21) and the n-type transport layer (22).

4. The wrapped photovoltaic cell according to claim 3, wherein a modification layer is arranged between adjacent layers of the photosensitive and charge transport layer (2);
a modification layer is arranged between the photosensitive and charge transport layer (2) and the inner electrode (1);
a modification layer is arranged between the photosensitive and charge transport layer (2) and the transparent outer electrode (3).

5. The wrapped photovoltaic cell according to claim 2 or 3, wherein the wrapped photovoltaic cell comprises a transparent protecting layer (4) which is wrapped outside the unit cell module.

6. The wrapped photovoltaic cell according to claim 5, wherein the photosensitive and charge transport layer (2) and the transparent outer electrode (3) are successively wrapped on the partial outer wall of the inner electrode (1), and the transparent protecting layer (4) is wrapped outside the outer electrode (3);
the unwrapped part of the inner electrode (1) forms the first lead (5);
or, the first lead (5) is led out by the unwrapped part of the inner electrode (1) to penetrate through the transparent protecting layer (4);
or, the first lead (5) is led out by the wrapped part of the inner electrode (1) to successively penetrate through the photosensitive and charge transport layer (2), the transparent outer electrode (3) and the transparent protecting layer 4.

7. The wrapped photovoltaic cell according to claim 5, wherein the photosensitive and charge transport layer (2), the transparent outer electrode (3) and the transparent protecting layer (4) are successively wrapped on all the outer walls of the inner electrode (1), and the first lead (5) successively penetrates through the charge transport layer, the transparent outer electrode (3) and the transparent protecting layer (4).

8. The wrapped photovoltaic cell according to claim 1, wherein the unit cell module comprises a plurality of photosensitive and charge transport layers (2), the photosensitive and charge transport layers (2) are successively wrapped between the inner electrode (1) and the transparent outer electrode (3), and a charge composite layer (8) is arranged between adjacent photosensitive and charge transport layers (2).

9. The wrapped photovoltaic cell according to claim 1, wherein the quantity of the unit cell modules is plural, and all the unit cell modules are connected in series or in parallel.

10. A photovoltaic module, comprising the wrapped photovoltaic cell according to any one of claims 1-9.
